**Europäisches Patentamt**

**European Patent Office**

**Office européen des brevets**

(11) Publication number : **0 469 236 B1**

# EUROPEAN PATENT SPECIFICATION

(45) Date of publication of patent specification :
**20.09.95 Bulletin 95/38**

(51) Int. Cl.⁶ : **H01J 37/30, H01J 37/08**

(21) Application number : **91105592.9**

(22) Date of filing : **09.04.91**

(54) **Apparatus for ion-plasma machining workpiece surfaces.**

(30) Priority : **30.07.90 SU 4855467**

(43) Date of publication of application :
**05.02.92 Bulletin 92/06**

(45) Publication of the grant of the patent :
**20.09.95 Bulletin 95/38**

(84) Designated Contracting States :
**CH DE FR GB IT LI NL SE**

(56) References cited :
**EP-A- 0 021 140**
**GB-A- 2 156 578**
**PATENT ABSTRACTS OF JAPAN, unexamined applications, E field, vol. 14, no. 161, March 28, 1990 THE PATENT OFFICE JAPANESE GOVERNMENT page 141 E 909**
**PATENT ABSTRACTS OF JAPAN, unexamined applications, E field, vol. 13, no. 5, January 9, 1989 THE PATENT OFFICE JAPANESE GOVERNMENT page 53 E 701**

(73) Proprietor : **HAUZER HOLDING B.V.**
**Groethofstraat 27**
**NL-5916 PA Venlo (NL)**

(72) Inventor : **Vladimirovich, Danysh Sergey**
**3rd Podbelskiy proezd, 16,**
**flat 15**
**107150 Moscow (SU)**
Inventor : **Ivanovna, Kolosova Galina**
**Svoboda ulitza, 63,**
**flat 274**
**12364 Moscow (SU)**
Inventor : **Nickolaevich, Lobanov Alexey**
**Stremyanniy pereulok, 33,**
**flat 15**
**113093 Moscow (SU)**
Inventor : **Vladimirovich, Obukhov Andrey**
**Bolotnikovskay ulitza, 30,**
**flat 18**
**113149 Moscow (SU)**
Inventor : **Alexeevich, Obukhov Vladimir**
**Petrozavodskay ulitza, 17,**
**flat 164**
**125502 Moscow (SU)**
Inventor : **Igorevich, Yurchenko Alexandr**
**Obrucheva ulitza, 16,**
**flat 100**
**117421 Moscow (SU)**

(74) Representative : **Dipl.-Phys.Dr. Manitz**
**Dipl.-Ing. Finsterwald Dipl.-Ing. Grämkow**
**Dipl.Chem.Dr. Heyn Dipl.Phys. Rotermund**
**Morgan, B.Sc.(Phys.)**
**Postfach 22 16 11**
**D-80506 München (DE)**

## Description

This invention relates generally to ion-plasma technology, and more particularly to apparatus for ion-plasma machining workpiece surfaces.

The invention can be used with success for designing production units intended to fabricate parts to be used in microelectronics, optics, superhight-frequency equipment, and the like by ion-plasma machining, such as by applying a flow of ions to workpiece surfaces.

There is known an apparatus for ion-plasma machining workpieces, such as depositing oxide films in an oxygen atmosphere by atomizing a material with an ion beam (cf., D.T. Wei "Ion Beam Interference Coating for Ultralow Optical Loss", Applied Optics, vol. 28, No. 14, 1989, pp. 2813 to 2816). This apparatus comprises a vacuum chamber accommodating a source of ion flow directed toward the target to deposit the material on the substrate. However, this apparatus makes use of a relatively high energy source of ions (several keV), such as a Kauffman source of ions.

Many production processes necessitate ion beams of substantially lower energy. For example, there is known an apparatus for ion-plasma machining workpiece surfaces (cf. EP-B-0021140) comprising a vacuum chamber accommodating a source of ion flow directed toward the surface to be machined. This apparatus is intended for ionic etching (atomization) of substrates from silicon-containing materials with an ion flow of low energy ( $\sim$ 100 eV). Workpieces facing by their surfaces toward the ion flow source are located in a fastening arrangement. As ions of low energy engage with the workpiece surface, the material is atomized without inflicting tangible radiation damage to the crystal materials. For increasing the rate of atomization use can be made of ions of chemically active gases, such as freons. In order to obtain a monoenergetic ion flow, a source of ions with plasma emitter and a single-electrode system for ion acceleration are used.

However, this prior art apparatus fails to produce active ion flows with an energy below 100 eV because the intensity of ion flow (flow density) is limited by the action of spatial charge of ions, and because of the ultimate perveance of beam $P = I_b U_o^{3/2}$, where I is the ion beam current [A] , and $U_o$ is the volt equivalent of ion energy [B] obtainable by an electrostatic acceleration system. Therefore, in response to a reduction in the energy of ions ($U_o$) the flow of ion beam and density of ion flow are diminished proportionally to $U_o^{3/2}$. Reduced flow in turn leads to a lower rate of machining and efficiency of the process. In practice, this results in a failure to machine workpiece surfaces at ion energy below 100 eV thereby limiting production capabilities of the apparatus.

There are known systems for decelerating an ion flow with a closed drift of electrons (cf., "Ionnye inzhektory i plazmennye uskoriteli", in Russian, edited by A.I. Morozov and N.N. Semashko, 1990, the Energoatomizdat Publishers, Moscow, pp. 213 to 217) comprising a magnetic system for excitation of a magnetic field across the flow of ions in an annular passage, and an annular decelerating electrode. These systems are generally applicable for decelerating narrow ( $\sim$ 1 cm thick) tubular ion flows, and for this reason cannot be used in ion-plasma machining units.

The present invention aims at providing an apparatus for ion-plasma machining workpiece surfaces capable of carrying out processes requiring the action of high-intensity monokinetic beams of low energy through decelerating the ion flow by an electric field produced in proximity to the workpiece surface being machined and running counter to the flow of ions.

The aim of the invention is attained by an apparatus for ion-plasma machining workpiece surfaces comprising a vacuum chamber accommodating a source of ion flow orientated toward the workpiece surface being machined. According to the invention, there is provided a system for decelerating the ion flow with closed electron drift including a shielding electrode with a hole for the passage of ion flow to the surface machining zone, a decelerating electrode electrically insulated from the walls of vacuum chamber and from the shielding electrode, fabricated from a non-magnetic material, and having secured thereon at least one workpiece to be machined, and a magnetic system made up of at least one pair of magnetic elements with the decelerating electrode interposed therebetween, vectors of magnetization of the magnetic elements of each pair being orientated relative to each other and to the surface of the decelerating electrode so that the vector of induction of the magnetic field is substantially parallel with the surface of the decelerating electrode.

For machining workpieces of substantial cross-sectional dimensions it is preferable that each magnetic element of one pair of magnetic elements be positioned relative to the corresponding magnetic element of the other pair so that vectors of their magnetization make an angle of more than 90°.

The highest magnitude of magnetic induction at continuous cross section of the workpiece to be machined can be attained if the angle between the vectors of magnetization of the magnetic elements is 180°.

To facilitate piece-by-piece machining of workpieces, each magnetic element should preferably have the form of a parallelepiped, whereas the decelerating electrode be fashioned as a plate of a length smaller than the length of the magnetic elements.

In order to enhance the effect of ion deceleration, especially when machining dielectric workpieces, it is preferable that each magnetic element be fashioned as a parallelepiped with a through hole whose axis runs in parallel with the vector of magnetization of the magnetic element, whereas the decelerating electrode have the shape conforming to the shape of the magnetic element and preferably be positioned so that its projection on the side surface of the magnetic element be within this side surface.

In order to improve the reliability of the apparatus in operation and to prevent electrical breakdowns in the decelerating system, the shielding electrode should preferably have the form of a box-shaped housing accommodating the magnetic system, the hole being advantageously made in the wall facing the ion flow.

For reducing the effect of magnetic field in the deceleration system on the operation of the source of ion flow, the shielding electrode is preferably fabricated from a magnetically soft material.

Obtaining a magnetic field of high strength at substantial interpole clearances in the deceleration system is possible when the magnetic elements are fabricated from a material posessing a high coersive force, such as $SmCo_6$.

In order to vary the energy of ions attacking the workpiece surface, it is advantageous that the apparatus be provided with a source of direct current whose positive terminal is connected to the decelerating electrode, and whose negative terminal is connected to the shielding electrode.

A higher stability in operation is attained if the shielding electrode is earthed.

With the same aim in view, it is favourable to provide a source of electrons located between the source of ion flow and shielding electrode.

For carrying out production processes during which a coating is applied to the workpiece surface being machined while simultaneously depositing atoms of preferred material on and bombarding the workpiece surface with ions of another material, the apparatus should preferably be provided with at least one source of the flow of atoms of the coating material orientated toward the workpiece surface being machined.

The proposed apparatus for ion-plasma machining workpiece surfaces provided with an ion flow deceleration system having a closed electron drift has wider ion-plasma machining capabilities thanks to reducing the energy of ions.

The invention will now be described in greater detail with reference to specific embodiments thereof taken in conjunction with the accompanying drawings, in which:

Fig. 1 is a general view of the proposed apparatus for ion-plasma machining workpiece surfaces;

Fig. 2 is a view of a system for decelerating the ion flow with one pair of magnetic elements in the form of parallelepipeds;

Fig. 3 shows a system for decelerating ion flow with two pairs of magnetic elements whose magnetization vectors make an angle of more than 90° therebetween;

Fig. 4 is a modified form of the deceleration system with two pairs of magnetic elements having an angle of 180° between their magnetization vectors;

Fig. 5 shows a deceleration system with one pair of magnetic elements in the form of parallelepipeds with a hole and a decelerating electrode shaped identically with the shape of the magnetic elements; and

Fig. 6 shows a deceleration system having the form of a periodic structure of elements of any of the shapes represented in Figs 2, 4 and 5.

Fig. 7 shows a modified form of the decelaration system according to the invention with a decelerating electrode which is provided with an additional electrode.

Fig. 8 shows the cross section of a deceleration system with the decelerating electrode being installed on an arrangement for moving the decelarating electrode into and out of the space between two pairs of magnetic elements.

Fig. 9 shows the principle of moving a number (for example three) of decelerating electrodes according to Fig. 8.

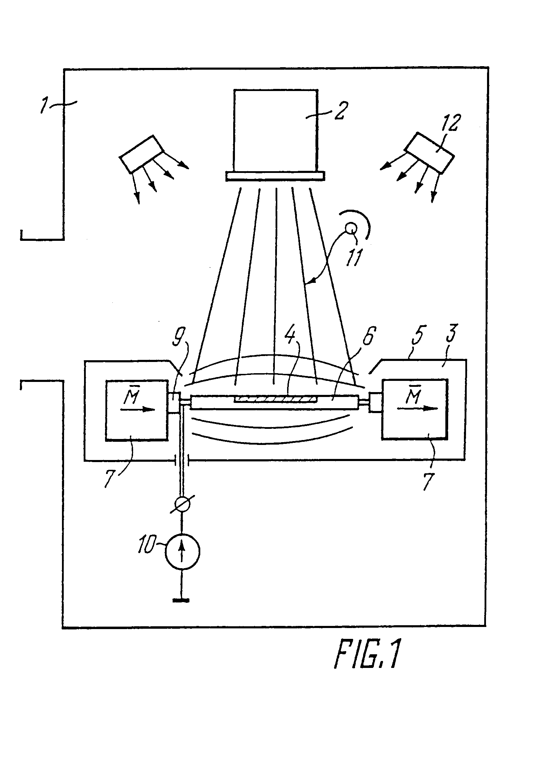

Apparatus for ion-plasma machining the surface of workpieces comprises a vacuum chamber 1 (Fig. 1) which accommodates a source 2 of ion flow and a system 3 for decelerating the ion flow with closed electron drift having workpieces 4 positioned therein. The system 3 includes a shielding electrode 5 fashioned as a box-shaped housing accommodating a decelerating electrode 6 and two magnetic elements 7.

Vectors $\vec{M}$ of magnetization of the magnetic elements 7 are so orientated that vector $\vec{B}$ of inductance of the magnetic field is substantially parallel with the surface of the decelerating electrode 6 fabricated from a non-magnetic material.

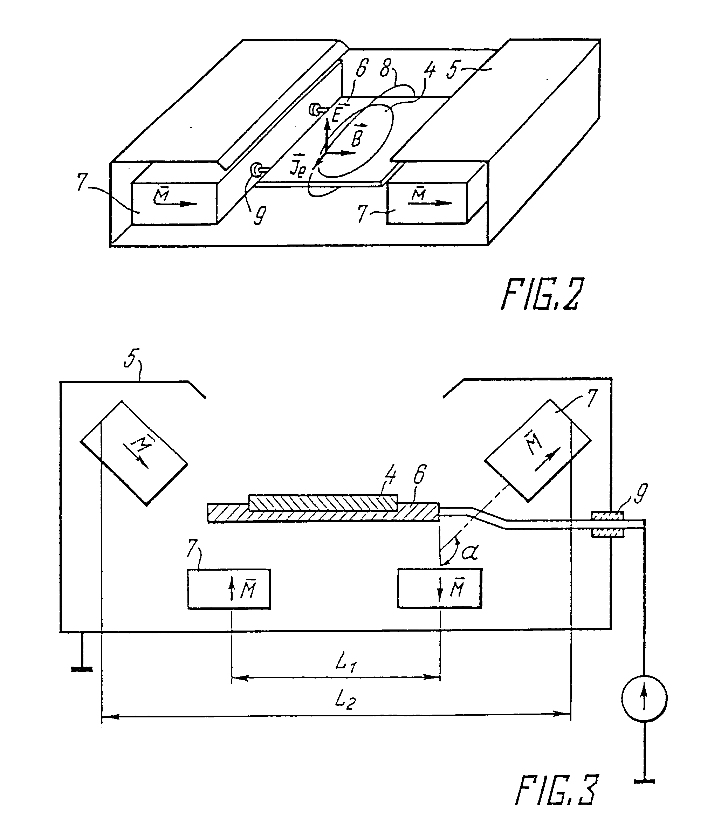

Therewith, line 8 (Fig. 2) of electron drift current perpendicular at any point thereof to the vector $\vec{B}$ and substantially parallel with the surface of decelerating electrode 6 is closed. Insulator units 9 (Fig. 1) for fastening the decelerating electrodes 6 are positioned so as not to hamper closing of this line 8 (Fig. 2). The apparatus can be provided with a source 10 (Fig. 1) of direct current whose positive terminal is connected to the decelerating electrode 6, and negative terminal is connected to the shielding electrode 5. The apparatus can also be provided with a source 11 of electrons, and with a source 12 of atoms of the coating material. The shielding electrode 5 can be earthed.

The magnetic elements 7 (Fig. 2) can have the form of successively magnetized parallelepipeds with the decelerating electrode 6 being interposed therebetween, the surface of this electrode 6 extending in parallel with the vectors $\vec{M}$ of magnetization of the elements 7.

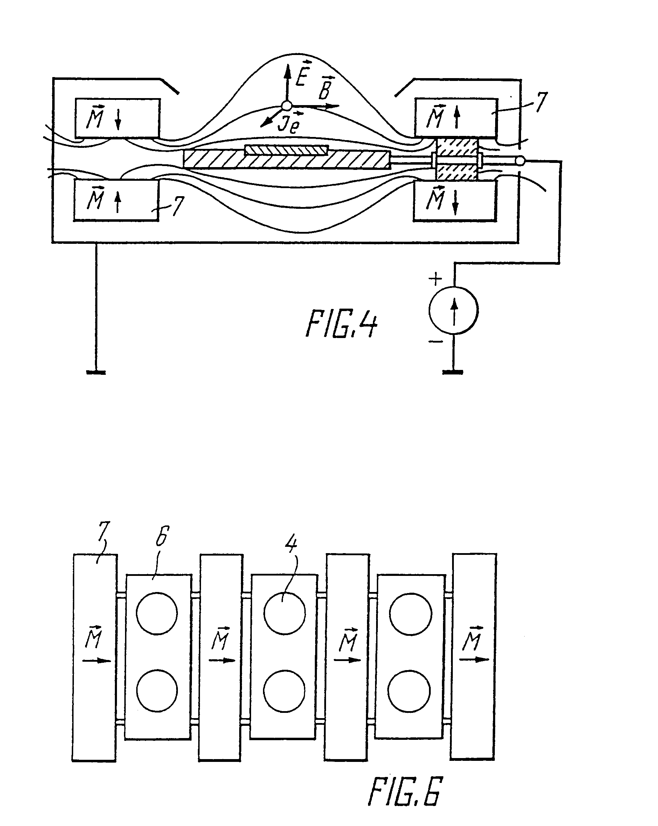

Referring now to Fig. 3, in the presence of two pairs of magnetic elements 7 shaped as parallelepipeds each magnetic element 7 of one such pair is positioned relative to the corresponding magnetic element 7 of the other pair so that their vectors $\vec{M}$ of magnetization make an angle $\alpha > 90°$, for example, $\alpha = 180°$ (Fig. 4). The decelerating electrode 6 is preferably positioned in an area where the vector $\vec{B}$ of inductance of the magnetic field is approximately parallel to its surface.

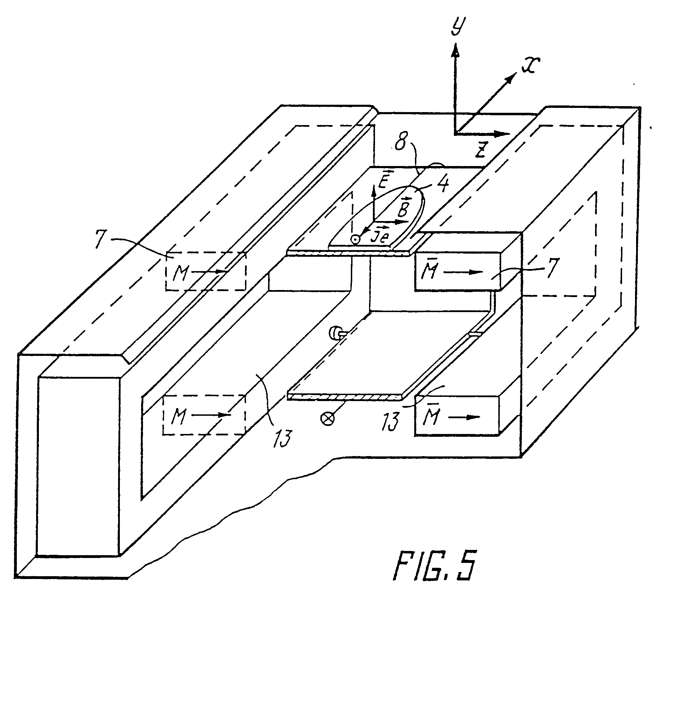

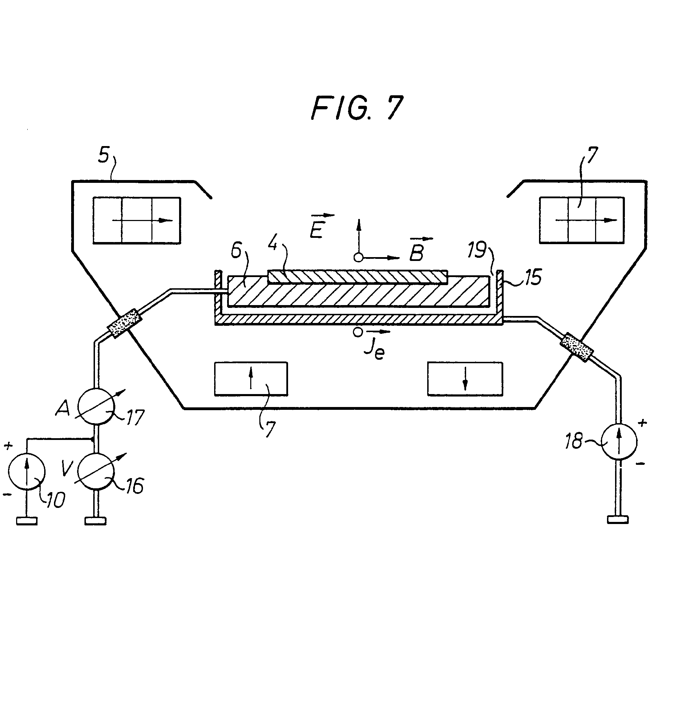

With reference to Fig. 5, magnetic elements 7 can have the form of parallelepipeds with a hole 13 whose axis is parallel with the magnetization vector $\vec{M}$. Therewith, the decelerating electrode 6 has a shape identical to the shape of magnetic elements 7, whereas the projection of the decelerating electrode 6 on the side surface of magnetic element 7 is within its area.

The "magnetic elements 7 - decelerating electrodes 6" system can have a periodic structure, and the magnetic elements 7 can have any of the aforedescribed shapes. The assembly can be provided with an additional electrode (15) in the form of a boxshaped housing accomodating the decelerating electrode (6) with a hole (19) in its wall facing the ion flow, as it is shown in Fig. 7. The additional electrode (15) is electrically insulated from the decelerating electrode (6). Thereby it is possible to connect the decelerating and the additional electrode with the positive terminal of one source (10) or with different (each for every electrode) sources (10, 18) of direct current as it is shown in Fig. 7.

One or more decelerating electrodes (6) can be installed on any arrangement with possibility of its (their) moving into and out of the area of machining.

All the aforedescribed configurations of magnetic systems as well as modifications and positioning of the decelerating electrodes 6 meet the prerequisite of closing the line 8 (Fig. 2) of electronic drift current $j_e$ in the direction of vector $\vec{E} \times \vec{B}$, where E is the strength of magnetic field, and B is the magnetic induction. The typical line 8 of this current is represented in Fig. 2. Insulator units 9 for fastening decelerating electrodes 6 are positioned so as not prevent free closing of current $j_e$. The electric field is maintained by the source 10 (Fig. 1) of direct current.

The source 11 of electrons is positioned between the source 2 of ion flow and system 3.

When ionically etching gallium arsenide crystals, the proposed apparatus operates in the following manner. Upon attaining a vacuum pressure of $\sim 10^2$ Pa, the source of ion flow is energized. Normally, the flow parameters of known ion flow sources are as follows: energy of ions $W_o \approx 20$ eV, and density of ionic flow $j_e = 1...2$ mA/cm$^2$.

However, for machining some materials, or for carrying out some processes the preferred energy of ions should be below 40 eV. This can be attained in the herein proposed apparatus. With this aim in view, applied to the decelerating electrode 6 relative to the shielding electrode 5 is a positive potential of a magnitude $eU = (W_o - 40)$ eV, where $e = 1.6 \times 10^{-19}$ Cb is the electron charge. In this case the machining zone of workpieces 4 has proper conditions for the presence of an electric layer (E-layer) where an electric field decelerating ions is maintained.

As follows from the physics of discharge of this type, maintaining the electric field fails to give rise to high energy electron flow on the workpiece 4 when conditions for closing the line 8 (Fig. 2) of electronic drift current are met: $j_e = e \cdot n_e \dfrac{[E \times B]}{B^2}$, where $n_e$ is the concentration of electrons, and square brackets contain a vector product. Lines 8 of this current must not cross the surface of workpiece 4 or any other structural elements. In this case no electric power of the direct current source 10 (Fig. 1) is consumed for maintaining this current, and the flow of electrons toward the surface of workpiece 4 is minimized. The proposed geometries of the system for decelerating ions ensure closing of line 8 (Fig. 2) of drift current. Experiments have shown that at the level of magnetic induction of $B \approx 0.05$ Tl the electron current can be equal to or even smaller than the ion current at the rate of deceleration of ions $W_f/W_o = 0.6...0.8$. At an energy of ions escaping from the source 2 of $W_o = 200$ eV their eventual energy $W_f$ at which they fall on the surface of the workpiece 4 amounts to $W_f \approx 40$ eV. If it is necessary that the electron current should substantially prevail over the ion current, such as for machining electrically conductive surfaces, even higher degrees of ion deceleration are attainable.

Calculations and experiments have shown that the required level of magnetic induction (0.02...0.05 Tl for various flow parameters) can be obtained in the herein proposed constructions for workpieces 4 sizing up to 200 mm when using magnetically hard materials of high coersive force, such as SmCo$_6$.

The shape of magnetic elements 7 is such as to be advantageous for machining specific workpieces 4 and to facilitate the machining process. For example, the use of a pair of magnetic elements 7 (Fig. 2) in the form of parallelepipeds is preferable for machining separate parts 4 sizing up to 5 mm across. With an increase in interpole distance to over the preferred one the magnitude of induction of the magnetic field at the middle of the workpiece 3 sharply drops to below the allowable level. The use of two pairs of magnetic elements 7 (Figs 3, 4) makes it possible to machine workpieces 4 of larger size. By varying the geometry of the system $L_1$, $L_2$ and $\alpha$ it is possible to vary the topography of the magnetic field. At $\alpha = 180°$ magnetic induction at the periphery of the workpiece 4 is maximized.

It is necessary to differetiate between ionic machining of electrically conductive and dielectric materials. In the case of machining a dielectric material equality between ion and electron currents (full current is zero) is automatically provided, whereby a certain positive potential of this surface relative to the potential of the shielding electrode 5 is established. The finite energy of ions with which they act on the workpiece surface here depends on the initial energy of ions and density of the ion flow, which are determined experimentally proceeding from process requirements.

Conversely, when machining electrically conductive workpieces 4, the potential of the decelerating electrode 6, and consequently the finite energy of ions are easily preset by varying the voltage at the terminals of the direct current source 10 (Fig. 1). Therewith, the current in the circuit of the decelerating electrode 6 can be either positive (ion current greater than electron current), or negative (inverse proportion between ion and electron currents).

In order to control the finite energy of ions when machining dielectric workpieces 4, it is advantageous to add a source of electrons 11 for controlling the potential of plasma activated in the vacuum chamber 1 by ion flow as it travels toward the workpiece 4 being machined. Provision of shielding electrode 5 in the form of a housing with holes to admit corpuscular flux makes electrical breakdowns between the decelerating and shielding electrodes 6 and 5 less likely. The workpieces 4 can be machined both at a floating potential and earthed shielding electrode 5. The manner in which the shielding electrode 5 is brought into the circuit of direct current source 10 influences the balance of electrons in the area of electron beam transport, and consequently affects the distribution of electric field in the zone of machining the workpieces 4. Normally, earthing of the shielding electrode 5 can lead to more stable operation of the apparatus, and also to a reduction in the ultimate rate of deceleration of ions when machining dielectric workpieces 4.

A wider range of varying the finite energy of ions can be attained by fashioning the magnetic elements 7 (Fig. 5) as parallelepipeds with a hole and shielding element 6 of similar shape. In this case it is easy to attain a uniform magnetic field lengthwise of the drift path of the electrons (along line 8), as seen best in Fig. 5. Such a uniformity ensures a higher rate of decelerating the ions.

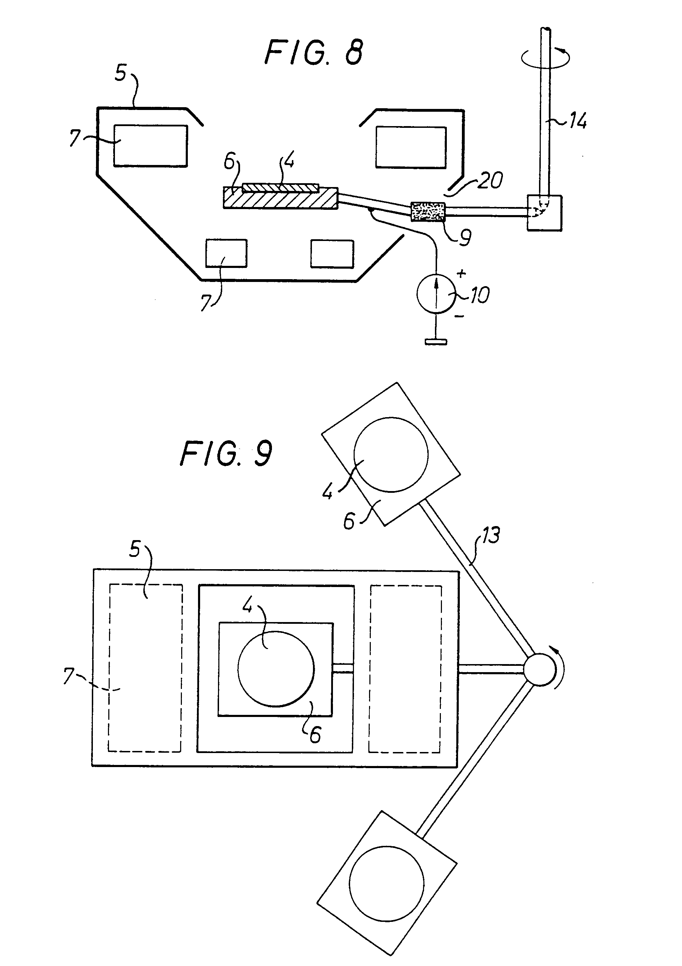

When machining a group of workpieces 4 (Fig. 6), especially small-size workpieces 4, it is preferable to use a periodic structure with magnetic elements 7 of any of the aforedescribed shapes.

In order to carry out a group of processes associated with obtaining dense metal layers on a dielectric substrate by depositing a flow of metal atoms accompanied by bombarding the substrate with a low energy flow of ions, or when applying metal oxide layers, it is advantageous to provide the apparatus with an atom flow source 12 (Fig. 1) of any known suitable construction, such as one of the evaporator type.

The machining of a group of workpieces (4) (Fig. 8, 9) can be organized using several decelerating electrodes installed on any arrangement with the possibility of its movement into the space between the two pairs of magnetic elements (7). In this case it is possible to carry out the processes of obtaining multilayer films, when the atom flow sources (12) (Fig. 1) operate one after another in accordance with moving one or one of a number of decelerating electrodes (6) in the area of machining.

The use of an additional electrode (15) results in a decreased electron-flow in the workpiece (4) because part of the flow occurs in the circuit of the additional electrode (15). This can be important if the temperature of the workpieces is limited under conditions of a certain technology. The lower level of the power contributed in the workpiece will occur when the additional electrode (16) is connected to the positive terminal of the source (10) of direct current whereas the decelerating electrode (6) is under floating potential (measured by voltmeter 16). Certainly the use of two separate sources (10 and 16) of direct current for the decelerating electrode and the additional electrode is possible. In this case the current in the circuit of the decelerating electrode is different from zero (measured by amperemeter 17).

In view of the aforedescribed, the invention allows an expansion in production capabilities of an apparatus for ion-plasma machining workpiece surfaces through reducing the lower level of ion energy to 30-50 eV, which makes the proposed apparatus amenable to novel technologies.

**Claims**

1. An apparatus for ion-plasma machining workpiece surfaces comprising a vacuum chamber (1) accommodating a source (2) of ion flow orientated toward the surface being machined, CHARACTERIZED in that it is provided with a system (3) for decelerating ion flow with closed electron drift including a shielding electrode (5) with a hole for the passage of ion flow to the surface machining zone, a decelerating electrode (6) electrically insulated from the walls of vacuum chamber (1) and from the shielding electrode (5), fabricated from a non-magnetic material, and having secured thereon at least one workpiece (4) to be machined, and a magnetic system made up of at least one pair of magnetic elements (7) with the decelerating electrode (6) interposed therebetween, vectors ( $\vec{M}$ ) of magnetization of the magnetic elements (7) of each pair being orientated relative to each other and to the surface of the decelerating electrode (6) so that vector ( $\vec{B}$ ) of induction of the magnetic field is substantially parallel with the surface of the workpiece being machined (4).

2. An apparatus for ion-plasma machining workpiece surfaces as claimed in claim 1, CHARACTERIZED in that in the presence of two pairs of magnetic elements (7) each magnetic element (7) of one such pair is positioned relative to the corresponding magnetic element (7) of the other pair so that vectors ( $\vec{M}$ ) of magnetization thereof make therebetween an angle ( $\alpha$ ) more than 90°.(Fig. 3)

3. An apparatus for ion-plasma machining workpiece surfaces as claimed in claim 2, CHARACTERIZED in that the angle ($\alpha$) between vectors ( $\vec{M}$ ) of magnetization of the magnetic elements (7) is 180°. (Fig. 4)

4. An apparatus for ion-plasma machining workpiece surfaces as claimed in claims 1 to 3, CHARACTERIZED, in that each magnetic element (7) has the form of a parallelepiped, whereas the decelerating electrode (6) has the form of a plate of a length smaller than the length of the magnetic elements (7).

5. An apparatus for ion-plasma machining workpiece surfaces as claimed in claims 1 to 3, CHARACTERIZED in that each magnetic element (7) has the form of a parallelepiped with a through hole (13) whose axis runs in parallel with vector ( $\vec{M}$ ) of magnetization of the magnetic element (7), whereas the decelerating electrode (6) has a shape similar to the shape of the magnetic element (7) and is positioned so that its projection on the side surface of the magnetic element (7) is within its range.

6. An apparatus for ion-plasma machining workpiece surfaces as claimed in claims 1 to 5, CHARACTERIZED in that the shielding electrode (5) has the form of a box-shaped housing accommodating the magnetic system, the hole for the passage of ion flow to the machining zone being provided in the wall facing the ion flow.

7. An apparatus for ion-plasma machining workpiece surfaces as claimed in claim 1, CHARACTERIZED in that the shielding electrode (5) is fabricated from a magnetically soft material.

8. An apparatus for ion-plasma machining workpiece surfaces as claimed in claim 1, CHARACTERIZED in that the magnetic elements (7) are fabricated from a magnetic material featuring high coersive force.

9. An apparatus for ion-plasma machining workpiece surfaces as claimed in claim 1, CHARACTERIZED in that it is provided with a source (10) of direct current whose positive terminal is connected to the decelerating electrode (6), and whose negative terminal is connected to the shielding electrode (5).

10. An apparatus for ion-plasma machining workpiece surfaces as claimed in claim 8, CHARACTERIZED in that the shielding electrode (5) is earthed.

11. An apparatus for ion-plasma machining workpiece surfaces as claimed in claim 1, CHARACTERIZED in that it is provided with a source (11) of electrons positioned between the source (2) of ion flow and shielding electrode (5).

12. An apparatus for ion-plasma machining workpiece surfaces as claimed in claim 1, CHARACTERIZED in that when applying coatings to the workpiece surface, the apparatus is preferably provided with at least one source (12) of atoms of the coating material orientated toward the surface being machined.

13. An apparatus for ion-plasma machining workpiece surfaces as claimed in claim 1, **characterized** in that it is provided with an additional electrode (15) which has the form of a box-shaped housing accomodating the decelerating electrode (6) with a hole (19) in its wall facing the ion flow electrically, and being insulated from the decelerating electrode (6).

14. An apparatus for ion-plasma machining workpiece surfaces as claimed in claim 13, **characterized** in that the positive terminal of a source of direct current (18) is connected to the additional electrode (15).

15. An apparatus for ion-plasma machining workpiece surfaces as claimed in claims 2 or 3, **characterized** in that it comprises at least one decelerating electrode (6) with at least one workpiece (4) to be machined secured thereon said electrode (6) being installed on an arrangement and can be moved into and out of the space between the two pairs of magnetic elements (7), whereas the shielding electrode (5) has another hole (20) for the passage of the decelerating electrode (6) therethrough.

## Patentansprüche

1. Eine Vorrichtung zur Ionenplasmabearbeitung von Arbeitsstückoberflächen mit einer Vakuumkammer (1), in der eine Quelle (2) eines Ionenflusses untergebracht ist, der in Richtung der Oberfläche, die bearbeitet wird, orientiert ist, dadurch gekennzeichnet, daß sie versehen ist mit einem System (3) zum Verzögern des Ionenflusses mit geschlossener Elektronendrift mit einer Abschirmelektrode (5), die ein Loch für den Durchgang des Ionenflusses zur Oberflächenbearbeitungszone aufweist, einer Verzögerungselektrode (6), die elektrisch von den Wänden der Vakuumkammer (1) und von der Abschirmelektrode (5) isoliert ist, aus einem nichtmagnetischen Material hergestellt ist und auf der wenigstens ein zu bearbeitendes Arbeitsstück (4) befestigt ist, und einem magnetischen System, das aus wenigstens einem Paar von Magnetelementen (7) besteht, wobei die Verzöaerungselektrode (6) dazwischengesetzt ist und Vektoren ($\vec{M}$) der Magnetisierung der Magnetelemente (7) jedes Paares relativ zueinander und zur Oberfläche der Verzögerungselektrode (6) so orientiert sind, daß der Vektor (B) der Induktion des Magnetfeldes im wesentlichen parallel zur Oberfläche des Arbeitsstücks (4), das bearbeitet wird, ist.

2. Eine Vorrichtung zur Ionenplasmabearbeitung von Arbeitsstückoberflächen wie in Anspruch 1 beansprucht, dadurch gekennzeichnet, daß beim Vorhandensein von zwei Paaren von Magnetelementen (7) jedes Magnetelement (7) des einen solchen Paares relativ zum entsprechenden Magnetelement (7) des anderen Paares so positioniert ist, daß die Vektoren ($\vec{M}$) ihrer Magnetisierung dazwischen einen Winkel ($\alpha$) von mehr als 90° bilden (Fig. 3).

3. Eine Vorrichtung zur Ionenplasmabearbeitung von Arbeitsstückoberflächen wie in Anspruch 2 beansprucht, dadurch gekennzeichnet,

daß der Winkel ($\alpha$) zwischen den Vektoren ($\vec{M}$) der Magnetisierung der Magnetelemente (7) 180° beträgt (Fig. 4).

4. Eine Vorrichtung zur Ionenplasmabearbeitung von Arbeitsstückoberflächen wie in den Ansprüchen 1 bis 3 beansprucht, dadurch gekennzeichnet, daß jedes Magnetelement (7) die Form eines Parallelepipeds aufweist, wohingegen die Verzögerungselektrode (6) die Form einer Platte besitzt, deren Länge kleiner als die Länge der Magnetelemente (7) ist.

5. Eine Vorrichtung zur Ionenplasmabearbeitung von Arbeitsstückoberflächen wie in den Ansprüchen 1 bis 3 beansprucht, dadurch gekennzeichnet, daß jedes Magnetelement (7) die Form eines Parallelepipeds mit einem Durchgangsloch (13) aufweist, dessen Achse parallel zum Vektor

($\vec{M}$) der Magnetisierung des Magnetelementes (7) verläuft, wohingegen die Verzögerungselektrode (6) eine Form ähnlich der Form des Magnetelements (7) besitzt und so positioniert ist, daß ihre Projektion auf der Seitenfläche des Magnetelements (7) innerhalb ihres Bereiches liegt.

6. Eine Vorrichtung zur Ionenplasmabearbeitung von Arbeitsstückoberflächen wie in den Ansprüchen 1 bis 5 beansprucht, dadurch gekennzeichnet, daß die Abschirmelektrode (5) die Form eines kastenförmigen Gehäuses aufweist, in welchem das Magnetsystem untergebracht ist, wobei das Loch für den Durchgang des Ionenflusses zur Bearbeitungszone in der dem Ionenfluß zugewandten Wand vorgesehen ist.

7. Eine Vorrichtung zur Ionenplasmabearbeitung von Arbeitsstückoberflächen wie in Anspruch 1 beansprucht, dadurch gekennzeichnet, daß die Abschirmelektrode (5) aus einem magnetisch weichen Material hergestellt ist.

8. Eine Vorrichtung zur Ionenplasmabearbeitung von Arbeitsstückoberflächen wie in Anspruch 1 beansprucht, dadurch gekennzeichnet, daß die Magnetelemente (7) aus einem magnetischen Material hergestellt sind, das eine hohe Koerzitivkraft darstellt.

9. Eine Vorrichtung zur Ionenplasmabearbeitung von Arbeitsstückoberflächen wie in Anspruch 1 beansprucht,

dadurch gekennzeichnet,

daß sie mit einer Gleichstromquelle (10) versehen ist, deren positiver Anschluß mit der Verzögerungselektrode (6) und deren negativer Anschluß mit der Abschirmelektrode (5) verbunden ist.

10. Eine Vorrichtung zur Ionenplasmabearbeitung von Arbeitsstückoberflächen wie in Anspruch 8 beansprucht,

dadurch gekennzeichnet,

daß die Abschirmelektrode (5) geerdet ist.

11. Eine Vorrichtung zur Ionenplasmabearbeitung von Arbeitsstückoberflächen wie in Anspruch 1 beansprucht,

dadurch gekennzeichnet,

daß sie mit einer Elektronenquelle (11) versehen ist, die zwischen der Ionenflußquelle (2) und der Abschirmelektrode (5) positioniert ist.

12. Eine Vorrichtung zur Ionenplasmabearbeitung von Arbeitsstückoberflächen wie in Anspruch 1 beansprucht,

dadurch gekennzeichnet,

daß, wenn Beschichtungen auf die Arbeitsstückoberfläche aufgebracht werden, die Vorrichtung vorzugsweise mit wenigstens einer Quelle (12) von Atomen des Beschichtungsmaterials versehen ist, die in Richtung der Oberfläche, die bearbeitet wird, orientiert ist.

13. Eine Vorrichtung zur Ionenplasmabearbeitung von Arbeitsstückoberflächen wie in Anspruch 1 beansprucht,

dadurch gekennzeichnet,

daß sie mit einer zusätzlichen Elektrode (15) versehen ist, welche die Form eines kastenförmigen Gehäuses, in welchem die Verzögerungselektrode (6) untergebracht ist, mit einem Loch (19) in ihrer dem Ionenfluß zugewandten Wand aufweist und von der Verzögerungselektrode (6) elektrisch isoliert ist.

14. Eine Vorrichtung zur Ionenplasmabearbeitung von Arbeitsstückoberflächen wie in Anspruch 13 beansprucht,

dadurch gekennzeichnet,

daß der positive Anschluß einer Gleichstromquelle (18) mit der zusätzlichen Elektrode (15) verbunden ist.

15. Eine Vorrichtung zur Ionenplasmabearbeitung von Arbeitsstückoberflächen wie in Anspruch 2 oder 3 beansprucht,

dadurch gekennzeichnet,

daß sie wenigstens eine Verzögerungselektrode (6) umfaßt, wobei wenigstens ein zu bearbeitendes Arbeitsstück (4) daran befestigt ist und die Elektrode (6) auf einer Anordnung eingerichtet ist und in den Raum zwischen den zwei Paaren von Magnetelementen (7) hinein und aus diesem heraus bewegt werden kann, während die Abschirmelektrode (5) ein weiteres Loch (20) für den Durchgang der Verzögerungselektrode (6) dorthindurch aufweist.

**Revendications**

1. Dispositif d'usinage au plasma de surfaces de pièces d'oeuvre, comprenant : une chambre à vide (1) contenant une source (2) d'écoulement d'ions orientée en direction de la surface en cours d'usinage, caractérisé en ce qu'il est muni d'un système (3) pour décélérer l'écoulement d'ions par circulation d' électrons en circuit fermé, incluant une électrode de blindage (5) avec un trou pour le passage de l'écoulement d'ions vers la zone d'usinage de surface, une électrode de décélération (6) isolée électriquement des parois de la chambre à vide (1) et de l'électrode de blindage (5), faite d'une matière non magnétique, et sur laquelle est fixée au moins une pièce d'oeuvre (4) à usiner, et un système magnétique constitué d'au moins une paire d'éléments magnétiques (7), l'électrode de décélération (6) étant interposée entre eux, les vecteurs ( $\overrightarrow{M}$ ) d'aimantation des éléments magnétiques (7) de chaque paire étant orientés l'un par rapport à l'autre et par rapport à la surface de l'électrode de décélération (6) de sorte que le vecteur ( $\overrightarrow{B}$ ) d'induction du champ magnétique soit sensiblement parallèle à la surface de la pièce d'oeuvre en cours d'usinage (4).

2. Dispositif d'usinage au plasma de surfaces de pièces d'oeuvre selon la revendication 1, caractérisé en ce qu'en présence de deux paires d'éléments magnétiques (7), chaque élément magnétique (7) d'une telle paire est positionné par rapport à l'élément magnétique (7) correspondant de l'autre paire de sorte que les vecteurs ( $\overrightarrow{M}$ ) de leur aimantation fassent entre eux un angle ($\alpha$) plus grand que 90° (figure 3).

3. Dispositif d'usinage au plasma de surfaces de pièces d'oeuvre selon la revendication 2, caractérisé en ce que l'angle ($\alpha$) entre les vecteur ( $\overrightarrow{M}$ ) d'aimantation des éléments magnétiques (7) est de 180° (figure 4).

4. Dispositif d'usinage au plasma de surfaces de pièces d'oeuvre selon les revendications 1 à 3, caractérisé en ce que chaque élément magnétique (7) a la forme d'un parallélépipède, tandis que l'électrode de décélération (6) a la forme d'une plaque d'une longueur plus petite que la longueur des éléments magnétiques (7).

5. Dispositif d'usinage au plasma de surfaces de pièces d'oeuvre selon les revendications 1 à 3, caractérisé en ce que chaque élément magnétique (7) a la forme d'un parallélépipède avec un trou traversant (13) dont l'axe s'étend parallèlement au vecteur ( $\overrightarrow{M}$ ) d'aimantation de l'élément magnétique (7), tandis que l'électrode de décélération (6) a une forme similaire à la forme de l'élément magnétique (7) et est positionnée de sorte que sa projection sur la surface latérale de l'élément magnétique (7) est à l'intérieur de son étendue.

6. Dispositif d'usinage au plasma de surfaces de pièces d'oeuvre selon les revendications 1 à 5, caractérisé en ce que l'électrode de blindage (5) a la forme d'un logement en forme de boîte contenant le système magnétique, le trou pour le passage de l'écoulement d'ions vers la zone d'usinage étant situé dans la paroi faisant face à l'écoulement d'ions.

7. Dispositif d'usinage au plasma de surfaces de pièces d'oeuvre selon la revendication 1, caractérisé en ce que l'électrode de blindage (5) est faite d'un matériau magnétique doux.

8. Dispositif d'usinage au plasma de surfaces de pièces d'oeuvre selon la revendication 1, caractérisé en ce que les éléments magnétiques (7) sont faits d'un matériau magnétique présentant un fort champ coercitif.

9. Dispositif d'usinage au plasma de surfaces de pièces d'oeuvre selon la revendication 1, caractérisé en ce qu'il est muni d'une source (10) de courant continu dont la borne positive est connectée à l'électrode de décélération (6), et dont la borne négative est connectée à l'électrode de blindage (5).

10. Dispositif d'usinage au plasma de surfaces de pièces d'oeuvre selon la revendication 8, caractérisé en ce que l'électrode de blindage (5) est mise à la masse.

11. Dispositif d'usinage au plasma de surfaces de pièces d'oeuvre selon la revendication 1, caractérisé en ce qu'il est muni d'une source (11) d'électrons située entre la source (2) d'écoulement d'ions et l'électrode de blindage (5).

12. Dispositif d'usinage au plasma de surfaces de pièces d'oeuvre selon la revendication 1, caractérisé en ce que, lors de l'application de revêtements à la surface de pièce d'oeuvre, le dispositif est muni, de préférence, d'au moins une source (12) d'atomes de la matière de revêtement, orientée en direction de la surface en cours d'usinage.

13. Dispositif d'usinage au plasma de surfaces de pièces d'oeuvre selon la revendication 1, caractérisé en ce qu'il est muni d'une électrode additionnelle (15) qui a la forme d'un logement en forme de boîte contenant l'électrode de décélération (6), avec un trou (19) dans sa paroi faisant face électriquement à l'écoulement d'ions, et étant isolé de l'électrode de décélération (6).

14. Dispositif d'usinage au plasma de surfaces de pièces d'oeuvre selon la revendication 13, caractérisé en ce que la borne positive de la source de courant continu (18) est connectée à l'électrode additionnelle (15).

15. Dispositif d'usinage au plasma de surfaces de pièces d'oeuvre selon les revendications 2 ou 3, caractérisé en ce qu'il comprend au moins une électrode de décélération (6) sur laquelle est fixée au moins une pièce d'oeuvre (4) à usiner, ladite électrode (6) étant installée sur un agencement et peut être déplacée dans et hors de l'espace entre les deux paires d'éléments magnétiques (7), tandis que l'électrode de blindage (5) comporte un autre trou (20) pour le passage, à travers lui, de l'électrode de décélération (6).

FIG.1

FIG.2

FIG.3

FIG.4

FIG.6

FIG. 5

# FIG. 7

# FIG. 8

# FIG. 9